# EUROPÄISCHE PATENTSCHRIFT

(11) **EP 0 564 917 B1**
(45) Veröffentlichungstag und Bekanntmachung des Hinweises auf die Patenterteilung: **28.07.1999**
(21) Anmeldenummer: 93104969.6
(22) Anmeldetag: 25.03.1993
(51) Int. Cl.: G03F 7/033, C08F 287/00, C08F 2/48

(54) **Lichthärtbares elastomeres Gemisch und daraus erhaltenes Aufzeichnungsmaterial für die Herstellung von Reliefdruckplatten**
Light-curable elastomeric mixture and recording material for flexographic printing plates obtained therefrom
Composition élastomère photodurcissable et matériau d'enregistrement obtenu de cela pour la production des plaques d'impression en relief

(30) Priorität: 04.04.1992 DE 4211391
(43) Veröffentlichungstag der Anmeldung: 13.10.1993
(73) Patentinhaber: Agfa-Gevaert AG, 51373 Leverkusen (DE)
(72) Erfinder: Gries, Willi-Kurt, Dr., W-6200 Wiesbaden (DE)

(56) Entgegenhaltungen:
- EP-A- 0 430 214
- DE-U- 9 016 662
- CHEMICAL ABSTRACTS, vol. 117, no. 12, 21. September 1992, Columbus, Ohio, US; abstract no. 112532, L.LIANG ET AL. 'Fabrication and characterisation of (poly(styrene-butadiene-4-vinylpyridine) triblockcopolymer' & GAOFENZI CAILIAO KEXUE YU GONGCHENG Bd. 7, Nr. 5 , 1991 Seiten 17 - 22

## Beschreibung

Die Erfindung betrifft ein lichthärtbares, negativ arbeitendes Gemisch und ein daraus erhaltenes Aufzeichnungsmaterial, das für die Herstellung von elastischen Reliefdruckplatten, Flachdruckplatten und Resistschichten geeignet ist.

Gemische der genannten Gattung sind bekannt und enthalten gewöhnlich ein elastomeres Bindemittel, eine radikalisch polymerisierbare Verbindung und einen durch aktinische Strahlung aktivierbaren Polymerisationsinitiator. Derartige Gemische, die z. B. in der DE-A 22 15 090 (= GB-A 1 366 769) beschrieben sind, verwenden als Bindemittel thermoplastische Blockcopolymerisate, die aus nichtelastomeren und elastomeren Blöcken bestehen, wobei die Entwicklung der belichteten Druckform zum Reliefbild durch organische Lösemittel erfolgt.

In den DE-A 27 25 730 (= US-A 4 042 386), DE-A 30 03 011 (= ZA 80/506), DE-A 33 22 994 (= US-A 4 554 240) und EP-A 0 130 828 werden zwar wäßrig entwickelbare Aufzeichnungsmaterialien auf der Basis teilverseifter Polyvinylacetat-Derivate beschrieben, jedoch ist die Wasserresistenz solcher Systeme gering, so daß ein Einsatz mit wasserverdünnbaren Druckfarben nicht möglich ist. Deshalb werden in den DE-A 30 12 841 (= US-A 4 272 608) und DE-A 35 43 646 (= US-A 4 916 045), EP-A 0 277 418, 0 261 910, 0 183 552, 0 251 228 und 0 273 393 sowie GB-A 2 179 360, US-A 4 517 279 und 4 446 220 Aufzeichnungsmaterialien auf der Basis carboxylgruppenhaltiger Dien-Elastomere vorgeschlagen. Wird in solchen Systemen der Carboxylgruppenanteil niedrig gehalten, so ist eine wäßrige Entwickelbarkeit nur schwer realisierbar und es ist erforderlich, einen hohen Anteil polarer Monomere bzw. Hilfsstoffe zuzusetzen, die ihrerseits einen hohen Kaltfluß des unbelichteten Materials zur Folge haben. Eine Erhöhung des Carboxylgruppengehaltes ergibt zwar eine verbesserte wäßrige Entwickelbarkeit, jedoch verschlechtern sich systembedingt die gummielastischen Eigenschaften dieser Materialien. Darüber hinaus reduziert sich die Resistenz gegenüber wasserenthaltende Druckfarben.

Neben dem Wunsch nach umweltfreundlicher Entwicklung der Reliefschichten ist eine Verbesserung spezieller Besonderheiten innerhalb des Druckvorgangs wünschenswert. Sollen z. B. nichtsaugende Bedruckstoffe wie Polyester-, Aluminium-, PVC- oder PVDC-Folien bedruckt werden, so kann eine ausreichende Farbdeckung und Trocknungsgeschwindigkeit der Farbe nur durch Vorhandensein sogenannter Beschleuniger realisiert werden. Meist handelt es sich dabei um organische Lösemittel wie Essigester, Propylacetat, Aceton, Methylethylketon, Methylisobutylketon u. a., die durch rasches Verdunsten den Trocknungsvorgang beschleunigen und darüberhinaus haftvermittelnd wirken können. Die bekannten "Photopolymer"-Reliefdruckformen sind jedoch gegenüber solchen Lösemitteln unzureichend beständig, d. h. durch starkes Aufquellen der Reliefschicht werden Abbildungsqualität und Auflagenhöhe vermindert. In der DE-A 38 03 457 (= US-A 4 994 344) werden flächenförmige, lichtempfindliche Aufzeichnungsmaterialien beschrieben, die günstige Quellungseigenschaften gegenüber den genannten Beschleunigern besitzen. Als Bindemittel kommen in solchen Systemen sogenannte EPM- bzw. EPDM-Elastomere zum Einsatz. Aufgrund ihrer gesättigten Polymerhauptkette sind diese Materialien weitgehend unpolar, so daß sich häufig bei der Herstellung photopolymerisierbarer Aufzeichnungsmaterialien Kompatibilitätsprobleme ergeben. Diese vielfach mangelnde Verträglichkeit mit olefinisch ungesättigten Monomeren, Polymerisationsinitiatoren, Farbstoffen, Weichmachern und anderen Zusatzstoffen führt dabei in der Regel zu Produkten unzureichender Verarbeitbarkeit sowie schlechter mechanischer bzw. reprotechnischer Qualität. Wie in der DE-A 39 05 947 (= US-A 5 147 757) beschrieben, müssen zur Eigenschaftsverbesserung sogenannte Compatibilizer eingearbeitet werden, die zwar das Verträglichkeitsproblem in solchen als Blends bezeichneten Materialien reduzieren, jedoch aufgrund definierter Phasenausbildung in der Regel in optisch transparenten Systemen ungeeignet sind bzw. als äußerst problematisch bezeichnet werden müssen.

Druckformen, wie sie in der DE-A 22 15 090 beschrieben sind, erfordern eine Ozonresistenz. Ozon entsteht z. B. bei der bildmäßigen Belichtung der photopolymerisierbaren elastomeren Schicht, insbesondere bei der Verwendung von UV-Licht, aber auch bei der Anwendung der belichteten und entwickelten Druckformen. Gerade hierbei treten besonders hohe Ozonkonzentrationen auf, insbesondere dann, wenn flexible Verpackungsmaterialien wie Papier oder Kunststoffe bedruckt werden. Da bei der Coronabehandlung erhebliche Mengen an Ozon entstehen und die Behandlung dann am wirkungsvollsten ist, wenn diese unmittelbar vor dem Druckvorgang stattfindet, gerät die Druckform in erheblichem Maße mit dem aus diesem Prozeß entstehenden Ozon in Kontakt. Erhöht wird die Anfälligkeit der entwickelten Druckform gegenüber Ozon noch dadurch, daß in den meisten Fällen eine Nachbehandlung der Druckform mit Halogen oder UV-C-Strahlung erfolgt, die notwendig ist, um deren Klebrigkeit zu reduzieren. In der DE-A 22 15 090 werden z.B. zur Erhöhung der Ozonresistenz der Photopolymermischung Wachse, bestimmte Thioharnstoffe, verschiedene Polymere u. a. zugesetzt.

Der Nachteil dieser Vorgehensweise ist, daß die genannten Zusätze oftmals nicht ausreichen, um die geforderte Resistenz gegenüber Ozon zu gewährleisten, oder wenn die wirksame Konzentration dieser Zusätze erhöht wird, das photopolymerisierbare Gemisch Trübungen in solchem Ausmaß aufweist, daß eine einwandfreie Belichtung nicht mehr erzielt werden kann. Andere Patente beschreiben Nachbehandlungsmethoden der entwickelten und behandelten Druckform mit z. B. Ni- oder Zn-Dialkyldithiocarbamaten (EP-A 0 137 331), flüssigen Polyethern (DE-A 35 12 632 = US-A 4 680 251) oder Polyamid-Lösungen (DE-A 34 15 044 = US-A 4 640 877). Abgesehen vom zusätzlichen Arbeitsschritt zeigen auf diese Weise behandelte Relief-Druckformen häufig nach kurzer Einwirkung von ozonhaltiger Luft erste Rißbildungen.

Aufgabe der Erfindung war es, Bindemittel für lichtempfindliche, elastomere Gemische vorzuschlagen, die unter Beibehaltung der thermoplastisch elastischen Eigenschaften entsprechend dem drucktechnischen Einsatz maßgeschneidert werden können.

Diese Aufgabe konnte nun überraschenderweise durch Einsatz symmetrischer bzw. unsymmetrischer Blockcopolymere mit einer an den jeweiligen Verwendungszweck angepaßten Segmentzusammensetzung als Bindemittel gelöst werden.

Gegenstand der Erfindung ist ein lichthärtbares elastomeres Gemisch, das als wesentliche Bestandteile
a) ein amphiphiles elastomeres Bindemittel bzw. ein Gemisch solcher Bindemittel,
b) eine radikalisch polymerisierbare, mit dem Bindemittel verträgliche Verbindung mit mindestens einer endständigen, ethylenisch ungesättigten Gruppe und einem Siedepunkt bei Normaldruck oberhalb 100 °C und
c) eine Verbindung oder eine Verbindungskombination enthält, die unter Einwirkung von aktinischem Licht die Polymerisation der Verbindung (b) einzuleiten vermag,
enthält, dadurch gekennzeichnet, daß das Bindemittel aus den Segmenten A, B und C aufgebaut ist, wobei
- A: einen hydrophoben weichen Block mit einer Glastemperatur T_{g} von unter -30 °C,
- B: einen hydrophoben harten Block mit einer Glastemperatur T_{g} von über +30 °C,
- C: einen polaren Block, der aus Vinylmonomeren und/oder durch anionische Ringöffnung polymerisierbaren heterocyclischen Verbindungen aufgebaut ist, wobei die Vinylmonomere Methacrylate, Vinylpyridine oder substituierte Vinylpyridine sind,
bedeuten.

Diese Blockcopolymerisate können auf mannigfache Weise aufgebaut sein, je nach dem, welche und wie viele dieser Segmente in dem Copolymerisat enthalten sind und wie diese Segmente miteinander verknüpft sind. Die Blockcopolymerisate können beispielsweise folgende Strukturen haben: A-B-C, A-B-A-C oder C-A-B-A-C. Ferner besteht die Möglichkeit, den Block C durch Copolymerisation verschiedener Monomeren aus verschiedenen Unterblöcken aufzubauen.

Gegenstand der Erfindung ist daben auch ein lichthärtbares, elastomeres Gemisch der obengenannten Art, das als Bindemittel ein Blockcopolymer der Struktur C-A-C enthält, wobei A und C die obengenannte Bedeutung haben.

Als Monomere für die Blockpolymerisate A sind konjugierte Diene, wie 1,3-Butadien, Isopren, 2,3-Dimethyl-1,3-butadien, 1,3-Pentadien, 2-Methyl-3-ethyl-1,3-butadien, 3-Methyl-1,3-Pentadien, 2-Methyl-3-ethyl-1,3-pentadien, 2-Ethyl-1,3-Pentadien, 1,3-Hexadien, 2-Methyl-1,3-hexadien, 1,3-Heptadien, 1,3-Octadien, 3,4-Dimethyl-1,3-hexadien und 2-Phenyl-1,3-butadien, in Betracht. Der Einsatz von Gemischen geeigneter Diene bzw. die Anwendung anderer anionisch polymerisierbarer konjugierter Diene mit 4 bis 12 Kohlenstoffatomen kommen ebenfalls in Betracht. Bevorzugt werden Isopren und 1,3-Butadien verwendet.

Als Monomere für die Segmente B sind Vinylaromaten, insbesondere Styrol, Alkylstyrol oder Vinylnaphthalin geeignet, wobei Styrol besonders bevorzugt ist.

Die Blöcke C bauen sich aus ethylenisch ungesättigten Verbindungen auf, wie Methacrylaten oder Vinylpyridinen. Beispiele hierfür sind Methyl-, n-Butyl-, t-Butyl-, Octyl-, Lauryl-, Octadecyl-, Phenyl-, Dimethylaminoethyl-methacrylat, 2- bzw. 4-Vinylpyridin oder substituierte Vinylpyridine. Die Blöcke C können außerdem aus heterocyclischen, durch anionische Ringöffnung polymerisierbaren Komponenten, wie Oxiranen, Thietanen, Lactonen, Cyclosiloxanen oder Lactamen bestehen. Beispielsweise seien hierfür Ethylenoxid, Propylenoxid, Butylenoxid, Phenyloxiran, Ethylensulfid, Propylensulfid, β-Propiolacton, ε-Caprolacton, Hexamethylcyclotrisiloxan, Octamethylcyclotetrasiloxan, Pyrrolidon, ε-Caprolactam erwähnt. Bevorzugt werden für den Aufbau des Blocks C t-Butylmethacrylat, Ethylenoxid, Ethylensulfid, 4-Vinylpyridin, ε-Caprolacton und Hexamethylcyclotrisiloxan eingesetzt.

Die Herstellung der beschriebenen Blockpolymerisate erfolgt nach an sich bekannten Methoden. Verwiesen sei hier auf G. Sylvester und P. Müller in Houben-Weyl-Müller, Methoden der Organischen Chemie E 20/2, 798ff. (1987) und G. Schröder in Houben-Weyl-Müller, Methoden der Organischen Chemie E20/2, 1141ff. (1987). Die Transformationsmethoden zur anionischen Ringöffnung und zur anionischen Addition sind bei P. Rempp, E. Franta und J.-E. Herz, Adv. Polym. Sci. 86, 145 (1988) und G. Riess, G. Hurtrez und P. Bahadur, Encyclopedia of Polymer Science and Engineering, 2, 324 (1985) beschrieben. Zu den üblichen Methoden zum Schutz von Carboxylgruppen sei auf T. W. Greene, Protective Groups in Organic Synthesis, Wiley Interscience, New York 1981, S. 168/169, verwiesen.

Zum Start der anionischen Polymerisation werden die üblichen lithiumorganischen Verbindungen R-Li verwendet, wobei unter R aliphatische, cycloaliphatische, aromatische oder gemischt aliphatisch aromatische Reste verstanden werden. Besonders erwähnenswert sind u. a. Methyllithium, Ethyllithium, (n-, sec.-, tert.-) Butyllithium, Isopropyllithium, Cyclohexyllithium, Phenyllithium und p-Tolyllithium. Außerdem können bifunktionelle, in unpolaren Medien aktive Initiatoren, wie sie beispielsweise durch radikalische Kupplung von Diphenylethen mittels Li-Metall entstehen oder durch Reaktion von Diisopropenyl-Benzolen mit Li-organischen Verbindungen gebildet werden, Verwendung finden. Bevorzugt zum Einsatz kommen sec.- bzw. n-BuLi sowie 1,4-Dilithio-1,1,4,4-tetraphenylbutan.

Die Copolymerisation wird unter den für die Handhabung von extrem feuchtigkeits- und sauerstoffempfindlichen Reagenzien üblichen Bedingungen durchgeführt, d. h. insbesondere, daß unter getrockneter Inertgasatmosphäre, z. B. unter einer Stickstoff- oder Argonatmosphäre, gearbeitet werden muß. Als Lösemittel werden aliphatische, cycloaliphatische und aromatische Kohlenwasserstoffe, wie Isobutan, n-Pentan, Isooctan, Cyclopentan, Cyclohexan, Cycloheptan, Benzol, Toluol oder Xylol sowie Gemische dieser Solventien eingesetzt. Es ist häufig zweckmäßig, in Gegenwart dipolarer, aprotischer Lösemittel zu arbeiten, um eine regioselektive Reaktion der Monomeren zu gewährleisten und so den Anteil an Produkten aus Nebenreaktionen gering zu halten. (Eine Reaktion wird als "regioselektiv" bezeichnet, wenn von zwei oder mehreren zur Reaktion befähigten Zentren eines Moleküls eines weit überwiegend oder allein reagiert.) Besonders bevorzugte dipolare, aprotische Lösemittel sind Ether, wie beispielsweise Tetrahydrofuran, Dimethoxyethan oder Methylphenylether. Zur Erzielung bestimmter Eigenschaften der Produkte erweist es sich als günstig, die anionische Copolymerisation in unpolaren, aprotischen Solventien zu beginnen, jedoch mit fortschreitendem Umsatz die Polarität des Solvens durch Zugabe stärker polarer Ether zu erhöhen. Der Volumenanteil der Ether kann dabei bis über 95 % des Gesamtlösemittelvolumens betragen.

Bei der Verwendung von Methacrylaten zum Aufbau des C-Blocks besitzen die anionischen Kettenenden häufig eine zu starke Nucleophilie. Vor der weiteren Copolymerisation ist daher eine Reduzierung der Nucleophilie des anionischen Kettenendes zweckmäßig. Dies läßt sich durch den Zusatz von ungesättigten Verbindungen der allgemeinen Formel CH₂=CR¹R² erreichen. R¹ und R² stehen dabei für Aryl- bzw. Alkylarylgruppen, insbesondere jedoch für gegebenenfalls substituierte Phenylgruppen. Doch sind auch 1-Phenyl-1-naphthylethen und seine Derivate brauchbar. Auch Styrole (R¹ = gegebenenfalls substituiertes Phenyl, R² H oder C₁-C₆-Alkyl) sind in manchen Fällen geeignet.

Für die anionische Ringöffnung der heterocyclischen Monomeren unter C kann es günstig sein, das relative Kettenende mit Ethylenoxid oder Ethylensulfid in das entsprechende Alkoholat bzw. Thiolat zu überführen.

Die Blockcopolymerisation wird in bekannter Weise durch sequentielle Addition der verschiedenen Monomere durchgeführt. Die Reaktionsführung erfolgt dabei in der Art, daß die zum Aufbau von Folgeblöcken notwendigen Vinylverbindungen erst nach weitgehendem Umsatz der bereits vorhandenen Monomere zugegeben werden. Die Reaktionstemperatur wird zwischen -80 °C und 120 °C eingestellt. Sie hängt sehr stark von der Natur des jeweiligen Monomeren ab. Vorzugsweise variieren die Temperaturen zwischen -72 °C und 60 °C. Nach Beendigung des gewünschten Blockaufbaus können die polymeren Anionen durch Protonenquellen, wie Alkohole, Wasser, Ammoniumchlorid oder HCl, desaktiviert werden.

Die durch Gelpermeationschromatographie (GPC) bestimmten Molekulargewichte bewegen sich zwischen 2.000 g/mol und 2.000.000 g/mol, vorzugsweise zwischen 15.000 g/mol und 200.000 g/mol. Die Massenanteile der beteiligten Blockkomponenten variieren von 20 bis 99 Gew.-% für A, 1 bis 50 Gew.-% für B und 1 bis 50 Gew.-% für C.

Die erfindungsgemäßen lichtempfindlichen Gemische enthalten im allgemeinen 20 bis 95 Gew.-%, vorzugsweise 30 bis 90 Gew.-%, des Bindemittels entweder ausschließlich oder in Verbindung mit anderen polymeren Materialien. Solche polymeren Materialien können chlorierte oder chlorsulfonierte Polyethylenverbindungen, statistisch aufgebaute oder segmentierte Dien-Polymere bzw. Copolymere sowie geeignete durch Polyaddition oder Polykondensation herstellbare thermoplastische Elastomere sein. Sie enthalten weiterhin mindestens eine radikalisch polymerisierbare olefinisch ungesättigte Verbindung sowie mindestens einen Photoinitiator.

Geeignete Monomere mit einer oder mehreren polymerisierbaren olefinischen Doppelbindungen sind insbesondere Ester und Amide der Acryl-, Methacryl-, Fumar- und Maleinsäure sowie Gemische dieser Verbindungen. Zusätzlich können die zur Ester- oder Amidbildung benötigten Alkohole bzw. Amine weitere Funktionalitäten, z. B. Ethereinheiten, Hydroxy-, prim., sek. oder tert. Aminogruppen enthalten. Beispiele für zur Esterbildung geeignete Alkohole sind offenkettige und cyclische Alkanole, wie Butanol, Hexanol, Octanol, Decanol, Dodecanol, Octadecanol, 2-Ethylhexanol, Cyclohexanol oder Borneol, aber auch Hydroxygruppen enthaltende Oligo- oder Polybutadiene und Hydroxygruppen enthaltende Oligo- oder Polyisoprene. Weitere geeignete Alkohole sind Alkandiole, polyfunktionelle Alkohole, und ähnliche Verbindungen, z. B. 1,4-Butandiol oder 1,6-Hexandiol, (Poly)ethylenglykol oder (Poly)propylenglykol, Glycerin, Trimethylolpropan, Butantriol, Pentaerythrit u. a. Die di- oder polyfunktionellen Alkohole können dabei teilweise oder vollständig verestert sein. Weitere Beispiele ungesättigter Verbindungen sind spezielle Ester und Amide der (Meth)acrylsäure, z. B. Dimethylaminoethyl(meth)acrylat, Dimethylaminopropyl(meth)acrylamid, 2-Butylaminoethyl(meth)acrylat, Ethylenbis(meth)acrylamid, Hexamethylenbis(meth)acrylamid, Diethylentriamintris(meth)acrylamid, Hydroxymethyl(meth)acrylamid und Bis-hydroxyethyl(meth)acrylamid.

Die Menge an Monomeren liegt im allgemeinen bei etwa 5 bis 70 Gew.-%, bevorzugt bei etwa 10 bis 50 Gew.-%, der nichtflüchtigen Bestandteile des Gemisches.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine ausreichende Radikalbildung bei Belichtung zur Initiierung der Polymerisation der Monomeren aufweisen. Sie sollen Licht im Wellenlängenbereich von ca. 250 nm bis 500 nm unter Bildung von Radikalen absorbieren. Beispiele geeigneter Photoinitiatoren sind Acyloine und deren Derivate wie Benzoin, Benzoinalkylether, 1,2-Diketone und deren Derivate, z. B. Benzil, Benzilacetale wie Benzildimethylketal, Fluorenone, Thioxanthone, mehrkernige Chinone, Acridine und Chinoxaline, ferner Trichlormethyl-s-triazine, 2-Halogenmethyl-4-vinyl-[1,3,4]oxadiazol, mit Trichlormethylgruppen substituierte Halogenoxazole, Trihalogenmethylgruppen enthaltende Carbonylmethylenheterocyclen, Acylphosphinoxid-Verbindungen und andere phosphorhaltige Photoinitiatoren, z. B. 6-Acyl-6H-dibenzo[c,e][1,2]oxaphosphorin-6-oxide, insbesondere das 6-(2,4,6-Trimethylbenzoyl)-6H-dibenzo[c,e][1,2]oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen.

Die Menge an Photoinitiator beträgt im allgemeinen etwa 0,01 bis 10 Gew.-%, bevorzugt etwa 0,5 bis 5 Gew.-%, des Aufzeichnungsmaterials.

Oft ist es von Vorteil, dem Aufzeichnungsmaterial noch weitere Hilfs- und Zusatzstoffe zuzugeben, z. B. solche, die die thermische Polymerisation inhibieren, wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Die erfindungsgemäßen Gemische lassen sich für die Herstellung von Relief- und Flexodruckplatten durch Gießen aus Lösung oder Extrudieren und Kalandrieren zu Schichten einer Dicke von 0,02 bis 6 mm, vorzugsweise von 0,2 bis 3 mm, verarbeiten. Die Schicht kann auf die Oberfläche eines geeigneten Trägers laminiert oder eine Lösung der erfindungsgemäßen Gemische kann direkt auf einen Schichtträger aufgebracht werden.

Außer für die Herstellung von Reliefdruckplatten können die erfindungsgemäßen Gemische auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol oder Polyamid, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die erfindungsgemäßen Aufzeichnungsmaterialien können bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit Wasser oder basischen, wäßrigen Lösungen erfolgen. Als basische Materialien kommen beispielsweise Hydroxide, Carbonate oder Hydrogencarbonate der Alkalimetalle, Ammoniak und organische Amine in Betracht. Ferner können Netz- und Emulgiermittel sowie mit Wasser mischbare organische Lösemittel, z. B. aliphatische Alkohole, Ethylenglykole und Ethylenglykolmonoether, zugesetzt werden. Der Anteil der basischen Komponenten an der Lösung beträgt im allgemeinen 0,01 bis 5 Gew.-%, bevorzugt 0,1 bis 1 Gew.-%. Der Anteil an organischem Lösemittel ist dabei kleiner als 40 Gew.-%, bevorzugt kleiner als 20 Gew.-%.

Alternativ können auch organische Lösemittel, wie aromatische Kohlenwasserstoffe, Chloralkane und Ketone als Entwickler verwendet werden. Beispiele dafür sind Toluol, Xylol, 1,1,1-Trichlorethan, Tetrachlorethylen, Methylisobutylketon u. a., die dabei auch in Kombination mit niederen Alkoholen, z. B. n-Butanol, eingesetzt werden können. Zweckmäßig werden die entwickelten Reliefformen bei Temperaturen bis 120 °C getrocknet und gegebenenfalls photochemisch oder chemisch nachbehandelt.

Die erfindungsgemäßen Aufzeichnungsmaterialien eignen sich besonders zur Herstellung von Druckformen, vor allem für den Flexodruck oder Flachdruck.

Die Erfindung wird durch die nachstehenden Beispiele erläutert. Wenn nichts anderes angegeben, stehen %-Angaben für Gew-%-Angaben.

### Herstellung der Blockcopolymere

### Herstellungsbeispiele 1 und 2 (Silicon-Block)

Die Herstellung des S-I-S-Polymerteils erfolgt in üblicher Weise. Dazu werden in einer trockenen, mehrfach evakuierten und mit vorgetrocknetem Stickstoff belüfteten Glasapparatur 270 ml wasserfreies Toluol oder Cyclohexan vorgelegt, 248 mmol trockenes Styrol hinzugefügt und mit 2,50 ml einer 1,6 M n-BuLi-Lösung in Hexan versetzt. Nach kurzer Zeit kommt die Polymerisation in Gang. Dann wird die Lösung 1 h auf 30 °C temperiert, mit 1,13 mol Isopren versetzt und 3 h in geschlossener Apparatur bei 30 °C Heizbadtemperatur gerührt. Nach Zugabe weiterer 248 mmol Styrol und einstündigem Rühren bei 30 °C werden zur Einführung des Siloxan-Blocks 144 mmol Hexamethylcyclotrisiloxan in 270 ml THF hinzugefügt. Das farblose Reaktionsgemisch wird noch 20 h auf 50 °C temperiert, anschließend mit 1 Mol-% 2,6-Di-t-Butyl-4-Hydroxytoluol versetzt, zur Ausfällung des Polymeren in das zehnfache Volumen Methanol eingesprüht, isoliert und getrocknet.
- **1**: S-I-S-Si₆ (16/48/16/20 %), Ausbeute = 90 %, GPC (THF): Mp (RI) = 61000, D = 1,05, Iodzahl = 186 g I₂/100 g
- **2**: S-I-S-Si₆ (8/64/8/20 %), Ausbeute = 85 %, GPC (THF): Mp (RI) = 53000, D = 1,17, Iodzahl = 204 g I₂/100 g

### Herstellungsbeispiele 3 bis 5 (Polyester-Block)

Der Aufbau des S-I-S-Anion-Blockes erfolgt in Analogie zu den Herstellungsbeispielen 1 und 2. Nach Beendigung des letzten Styrol-Schritts wird eine dem Toluol bzw. dem Cyclohexan äquivalente Menge THF zugegeben und mit einer Eis/Wasser-Mischung auf unter 10 °C abgekühlt. Man versetzt mit - bezogen auf den Starter - 10 Äquivalenten Ethylenoxid, rührt unter Beibehaltung der Kühlung 30 min, fügt die entsprechende Menge ε-Caprolacton hinzu und erhitzt schließlich bei geschlossenem Reaktionsgefäß 11 h auf 50 °C. Das dickflüssige Reaktionsgemisch wird mit 2,6-Di-t-Butyl-4-Hydroxytoluol stabilisiert und durch Einsprühen in Methanol ausgefällt bzw. isoliert.
- **3**: S-I-S-ε-CL (16/48/16/20 %), Ausbeute = 93 %, GPC (THF): Mp (RI) = 62000, D = 1,06, Iodzahl = 158 g I₂/100 g
- **4**: S-I-S-ε-CL (10/50/10/30 %), Ausbeute = 70 %, GPC (THF): Mp (RI) = 100000, D = 1,03, Iodzahl = 243 g I₂/100 g
- **5**: S-I-S-ε-CL (8/64/8/20 %), Ausbeute = 77 %, GPC (THF): Mp (RI) = 53000, D = 1,01, Iodzahl = 247 g I₂/100 g

### Herstellungsbeispiel 6 (Ethylenglykol-Block)

Die Reaktion wird in gleicher Weise wie in den Beispielen 3, 4 und 5 durchgeführt, jedoch erfolgt die Ethylenoxid-Polymerisation über 15 h in einer geschlossenen Apparatur bei Raumtemperatur.
- **6**: S-I-S-EO (8/64/8/20 %), Ausbeute = 67 %, GPC (THF): Mp (RI) = 164000, D = 1,08, Iodzahl = 243 g I₂/100 g

### Herstellungsbeispiele 7 und 8 (Ethylensulfid-Block)

Die Reaktion wird in gleicher Weise wie in den Beispielen 3, 4 bzw 5 durchgeführt, jedoch erfolgt die Ethylensulfid-Polymerisation über 17 h bei Raumtemperatur, und es wird zusätzlich 1,2-Dimethoxyethan anstatt THF als Lösungsmittel verwendet.
- **7**: S-I-S-ES (8/64/8/20 %), Ausbeute = 88 %, GPC (THF): Mp (RI) = 62000, D = 1,09
- **8**: S-I-S-ES (8/74/8/10 %), Ausbeute = 87 %, GPC (THF): Mp (RI) = 122000, D = 1,09

### Herstellungsbeispiel 9 (Vinylpyridin-Block)

Die Reaktion wird in gleicher Weise wie in den Beispielen 3, 4 bzw. 5 durchgeführt, jedoch erfolgt die 4-Vinylpyridin-Polymerisation über 19 h bei Raumtemperatur, wobei vor der Zugabe des Monomeren mit einer Eis/Wasser-Mischung gekühlt wird.
- **9**: S-I-S-4-VP (8/64/8/20 %), Ausbeute = 93 %, GPC (THF): Mp (RI) = 70000, D = 1,22

### Herstellungsbeispiel 10 (t-Butylmethacrylat-Block)

Der Aufbau des S-I-S-Anion-Blockes erfolgt in Analogie zu den Herstellungsbeispielen 1 und 2. Nach Beendigung des letzten Styrol-Schritts wird - bezogen auf den Starter - mit 2 Äquivalenten 1,1-Diphenylethen versetzt, ein der Toluol- bzw. Cyclohexanmenge entsprechendes Volumen an THF zugegeben und mit einer Eis/Wasser-Mischung auf unter 10 °C Innentemperatur abgekühlt. Unter Beibehaltung der Kühlung wird die berechnete Menge t-Butylmethacrylat zugegeben, noch 1 h gerührt und mit Methanol terminiert. Stabilisierung und Aufarbeitung entsprechen Herstellungsbeispiel 1.
- **10**: S-I-S-tBuMA (8/64/8/20 %), Ausbeute = 89 %, GPC (THF): Mp (RI) = 71000, D = 1,19

### Herstellungsbeispiele 11 bis 13 (amphoterer Methacrylat-Block)

Der Aufbau des S-I-S-Anion-Blockes erfolgt in Analogie zu den Herstellungsbeispielen 1 und 2. Nach Beendigung der Styrol-Polymerisation werden, bezogen auf den Starter, 2 Äquivalente 1,1-Diphenylethen zugegeben, mit 300 ml THF verdünnt, 15 min. bei Raumtemperatur gerührt und anschließend auf -72 °C abgekühlt. Die dunkelrote, zähflüssige Reaktionsmischung wird zuerst mit der berechneten Menge an t-Butylmethacrylat versetzt und 1 h im Kältebad gerührt. N,N-Dimethylaminoethylmethacrylat wird entsprechend der gewünschten Zusammensetzung hinzugefügt. Die Reaktionsmischung wird noch 1 h im Kältebad belassen und mit Methanol bei -72 °C terminiert. Die Stabilisierung bzw. Aufarbeitung erfolgt wie bei 1 und 2 beschrieben. Zur Entfernung der t-Butyl-Schutzgruppe wird das isolierte Material in Toluol gelöst, mit 5 Gew.-% p-Toluolsulfonsäure - bezogen auf den t-Butylmethacrylat-Anteil - versetzt, auf 80 °C erwärmt und 6 h bei dieser Temperatur gehalten. Nach dem Abkühlen wird mit MeOH ausgefällt, gewaschen und im Vakuum bei Raumtemperatur getrocknet.
- **11**: S-I-S-MMA-DMAEMA (8/64/8/10/10 %), Ausbeute = 97 %, GPC (THF): Mp (RI) = 100000, D = 1,14
- **12**: S-I-S-MMA-DMAEMA (22/16/22/30/10 %), Ausbeute = 77 %, GPC (THF): Mp (RI) = 87000, D = 1,32
- **13**: S-I-MMA-DMAEMA (10/70/10/10 %), Ausbeute = 99 %, GPC (THF): Mp (RI) = 45000, D = 1,20

Die in den obigen Beispielen benutzten Abkürzungen, soweit nicht allgemein gebräuchlich, haben folgende Bedeutung:
- S: = Styrol
- I: = Isopren
- Si₆: = Hexamethylcyclotrisiloxan
- DMAEMA: = Dimethylaminoethylmethacrylat
- 4-VP: = 4-Vinylpyridin
- ε-CL: = ε-Caprolacton
- EO: = Ethylenoxid
- ES: = Ethylensulfid
- tBuMA: = tert. Butylmethacrylat
- MMA: = Methylmethacrylat

Die GPC-Untersuchungen wurden in Tetrahydrofuran mit Polystyrol-Standards als Bezugsmolekulargewicht durchgeführt.

### Beispiele 1 bis 13 (Herstellung der Flexodruckplatten)

Die in den folgenden Tabellen angegebenen Produkte in den ebenfalls angegebenen Mengen wurden in einem Kneter (Brabender Plasticorder) bei 80 U/min und einer Temperatur von 120 °C homogenisiert. Die erhaltene klare Masse wurde anschließend in einer Plattenpresse zwischen zwei 0,125 mm dicken Polyesterfolien bei 120 °C 1,5 min/15 bar und dann 2 min/35 bar auf 3 mm Gesamtschichtdicke gepreßt. Von den Folien war eine mit einer Haftschicht und die andere mit einer wasserlöslichen oder in organischen Lösemitteln löslichen Anti-Tack-Schicht versehen. Haft- und Anti-Tack-Schicht waren dabei auf der Seite, die der photopolymerisierbaren Masse zugewandt ist. Nach 20 s Rückseitenbelichtung wurde die Deckfolie abgezogen. Dann wurde das Aufzeichnungsmaterial mit einer aufgelegten Photomaske 8 min in einem UV-A-Flachbelichter bildmäßig belichtet und anschließend in einem Flachbürstenentwicklungsgerät bei 60 °C (für wäßrige Lösemittel) oder bei Raumtemperatur (für organische Lösemittel) innerhalb von 8 min jeweils in den in Tabelle V angegebenen Lösemitteln entschichtet. Die nachbelichteten Druckplatten wiesen die in den Tabellen I bis IV angegebenen Shore-A-Härten (30 s) auf und ergaben in Wasser, in Ethanol bzw. einem Gemisch aus 85 Teilen Ethanol und 15 Teilen Ethylacetat die jeweils angegebenen Quellungswerte, ausgedrückt als relative Gewichtszunahme in Prozenten nach 24 h.

Die Fälle, bei denen eine Entschichtung stattfindet, sind mit +, die Fälle in denen keine Entschichtung erfolgt, sind mit - gekennzeichnet, während o für eine teilweise Entschichtung steht.

Die Flexodruckplatten nach den Beispielen 4 bis 10 wurden darüber hinaus auf ihre Beständigkeit gegenüber der Einwirkung von Ozon geprüft gemäß der in DE-A 38 41 854, Beispiel 1, beschriebenen Methode (Einwirkungsdauer 37 bzw. 72 Stunden bei Raumtemperatur). Die Zahl 1 bedeutet keine Risse, 2 kleine Risse am Rand, 3 Risse und 4 starke Risse.

**Tabelle I**

| Zusammensetzung | Vergleichsbeispiel | Beispiele | |
|---|---|---|---|
| | | 2 | 3 |
| Polymer nach Beispiel 6 | - | - | 25,65 |
| | | | |
| Polymer nach Beispiel 7 | - | 25,65 | - |
| | | | |
| Blockcopolymer aus S-I-S (^{(R)} Europrene Sol T 190) | 25,65 | - | - |
| | | | |
| Hexandioldiacrylat | 1,2 | 1,2 | 1,2 |
| | | | |
| Hexandioldimethacrylat | 0,6 | 0,6 | 0,6 |
| | | | |
| 2,6-Di-tert.-butyl-4-methylphenol | 0,3 | 0,3 | 0,3 |
| | | | |
| Benzildimethylketal | 0,45 | 0,45 | 0,45 |
| | | | |
| Fettschwarz HB | 0,003 | 0,003 | 0,003 |
| | | | |
| Med. Weißöl | 1,8 | 1,8 | 1,8 |

| Eigenschaften | | | |
|---|---|---|---|
| Härte (Shore A/30 s) | 21 | 30 | 26 |
| | | | |
| Quellung (%) | | | |
| | | | |
| H₂O | 0,40 | 0,65 | 0,53 |
| | | | |
| EtOH | - | - | - |
| | | | |
| EtOH/EtOAc (85/15) | 2,67 | 5,21 | 4,05 |

**Tabelle II**

| Zusammensetzung | Beispiele | | |
|---|---|---|---|
| | 4 | 5 | 6 |
| Polymer nach Beispiel 6 | - | - | 20,4 |
| | | | |
| Polymer nach Beispiel 7 | - | 20,4 | - |
| | | | |
| Polymer nach Beispiel 9 | 20,4 | - | - |
| | | | |
| Tripropylenglykoldiacrylat | 3,0 | 3,0 | 3,0 |
| | | | |
| Maleinsäure-mono-2-acryloyl-oxyethylenester | 1,5 | 1,5 | 1,5 |
| | | | |
| Benzildimethylketal | 0,3 | 0,3 | 0,3 |
| | | | |
| Fettschwarz HB | 0,0003 | 0,0003 | 0,0003 |
| | | | |
| COOH-haltiges, flüssiges Polyisopren | 2,85 | 2,85 | 2,85 |
| | | | |
| Med. Weißöl | 1,8 | 1,8 | 1,8 |

| Eigenschaften | | | |
|---|---|---|---|
| Härte (Shore A/30 s) | 27 | 42 | 32 |
| | | | |
| Quellung (%) | | | |
| | | | |
| H₂O | 1,37 | 0,58 | 0,83 |
| | | | |
| EtOH | 4,63 | 0,79 | 1,05 |
| | | | |
| EtOH/EtOAc (85/15) | 12,1 | 4,4 | 5,01 |
| | | | |
| EtOH/EtOAc (50/50) | 35,1 | 19,4 | 21,7 |
| | | | |
| EtOH/EtOAc/MEK (50/25/25) | 35,7 | 19,4 | 18,9 |

**Tabelle III**

| Zusammensetzung | Beispiele | | | |
|---|---|---|---|---|
| | 7 | 8 | 9 | 10 |
| Polymer nach Beispiel 2 | - | - | 25,5 | - |
| | | | | |
| Polymer nach Beispiel 4 | - | 25,5 | - | - |
| | | | | |
| Polymer nach Beispiel 9 | - | - | - | 25,5 |
| | | | | |
| Polymer nach Beispiel 10 | 25,5 | - | - | - |
| | | | | |
| Hexandioldiacrylat | 1,2 | 1,2 | 1,2 | 1,2 |
| | | | | |
| Hexandioldimethacrylat | 0,6 | 0,6 | 0,6 | 0,6 |
| | | | | |
| Benzildimethylketal | 0,45 | 0,45 | 0,45 | 0,45 |
| | | | | |
| Fettschwarz HB (Solvent Black 3) | 0,0003 | 0,0003 | 0,0003 | 0,0003 |
| | | | | |
| Med. Weißöl | 1,8 | 1,8 | 1,8 | 1,8 |
| | | | | |
| 2,6-Di-tert.-butyl-4-methylphenol | 0,3 | 0,3 | 0,3 | 0,3 |

| Eigenschaften | | | | |
|---|---|---|---|---|
| Härte (Shore A/30 s) | 24 | 10 | 7,0 | 32 |
| | | | | |
| Quellung (%) | | | | |
| | | | | |
| H₂O | 0,11 | - | 0,11 | 0,80 |
| | | | | |
| EtOH | 15,7 | 1,04 | - | 4,86 |
| | | | | |
| EtOH/EtOAc (85/15) | 55,9 | 7,80 | 4,07 | 13,8 |

**Tabelle IV**

| Zusammensetzung | Beispiele | | |
|---|---|---|---|
| | 11 | 12 | 13 |
| Polymer nach Beispiel 13 | 19,2 | 19,2 | 19,2 |
| | | | |
| Benzildimethylketal | 0,3 | 0,3 | 0,3 |
| | | | |
| 2,6-Di-tert.-butyl-4-methylphenol | 0,15 | 0,15 | 0,15 |
| | | | |
| Med. Weißöl | 3,0 | 3,0 | 3,0 |
| | | | |
| COOH-haltiges, flüssiges Polyisopren | 2,85 | 2,85 | 2,85 |
| | | | |
| Tripropylenglykoldiacrylat | 3,0 | 3,0 | 3,0 |
| | | | |
| Dimethylaminopropylmethacrylamid | 1,5 | - | - |
| | | | |
| Maleinsäure-mono-2-acryloyl-oxyethylenester | - | 1,5 | - |
| | | | |
| Hexandioldimethacrylat | - | - | 1,5 |

| Eigenschaften | | | |
|---|---|---|---|
| Härte (Shore A/30 s) | 21 | 31 | 30 |
| | | | |
| Quellung (%) | | | |
| | | | |
| H₂O | 0,83 | 1,14 | 0,76 |
| | | | |
| EtOH | 5,28 | 3,24 | 3,65 |
| | | | |
| EtOH/EtOAc (85/15) | 17,2 | 11,1 | 12,9 |

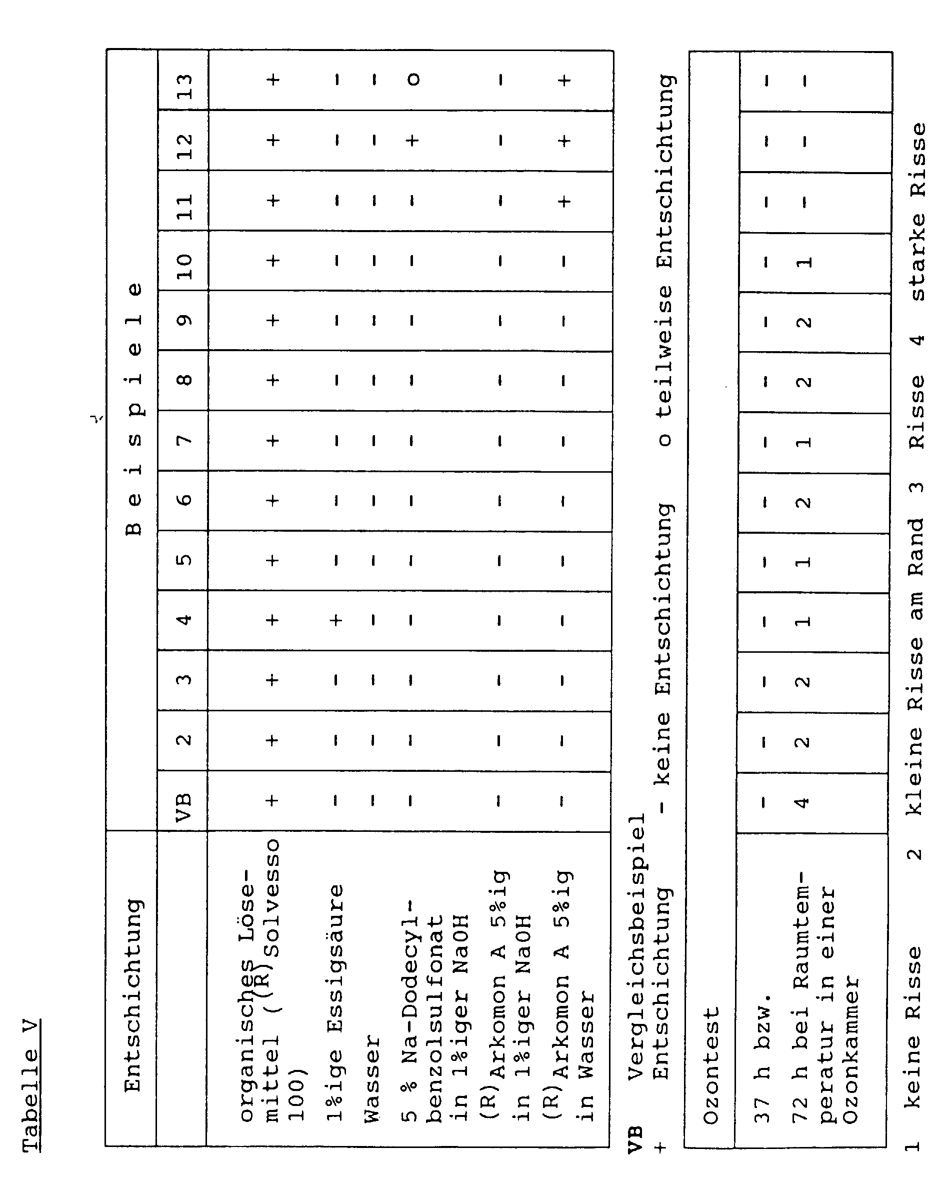

### Beispiele 14 und 15 (Offsetdruckplatten)

Eine Beschichtungslösung aus

| | |
|---|---|
| 6,59 g | des gemäß Herstellungsbeispiel 11 synthetisierten Blockcopolymeren mit einem Anteil von 16 % Styrol, 74 % Isopren und 10 % N,N-Dimethylaminoethylmethacrylat, |
| 6,59 g | Trimethylolpropan-triacrylat, |
| 0,118 g | Phenylacridin, |
| 0,141 g | Samaronmarineblau HR (Disperse Blue 290), |
| 0,118 g | Dibenzalaceton und |
| 400 g | Tetrahydrofuran |

wurde auf einen 0,3 mm starken in Salpetersäure aufgerauhten, in Schwefelsäure anodisierten und mit einer 0,1%igen wäßrigen Lösung von Polyvinylphosphonsäure nachbehandelten Aluminiumträger aufgegebracht. Das Schichtgewicht betrug 1,0 g/m². Die Platte wurde anschließend mit einer 3,5%igen wäßrigen Lösung eines Polyalkylenoxid-Polyvinylalkohol-Pfropfpolymeren (Hoechst: ^{(R)} Mowiol 04/Ml) überzogen (Schichtgewicht nach dem Trocknen 0,8 g/m²). Die erhaltene Druckplatte wurde mittels einer 5-kW-Metallhalogenidlampe im Abstand von 110 cm 40 s unter einem Belichtungskeil sowie verschiedenen anderen Testelementen aus Mikrolinien und Spitzpunktfeldern belichtet. Nach der Belichtung wurde die Platte mit einem Entwickler (5%iges Na-Dodecylbenzolsulfonat in einer 1%igen Natriumcarbonatlösung) mit einem Plüschtampon behandelt.

Die nichtbelichteten Schichtbereiche wurden innerhalb weniger Sekunden sauber entfernt, wobei eine Kopie mit sehr hoher Auflösung und guter Farbannahme erhalten wurde.

Gleich gute Ergebnisse wurden mit einer Druckplatte erhalten, die mit folgender Mischung beschichtet wurde:

| | |
|---|---|
| 4,80 g | des gemäß Herstellungsbeispiel 12 synthetisierten Blockcopolymeren mit einem Anteil von 44 % Styrol, 16 % Isopren, 30 % Methacrylsäure und 10 % Dimethylaminoethylmethacrylat, |
| 4,00 g | Trimethylolpropan-triacrylat, |
| 0,700 g | N,N-Dimethylaminopropyl-methacrylamid, |
| 0,150 g | Benzildimethylketal, |
| 0,050 g | 2,6-Di-tert.-butyl-4-methylphenol, |
| 0,010 g | Fettschwarz HB (Solvent Black 3) und |
| 104 g | Tetrahydrofuran. |

Das Schichtgwicht der lichtempfindlichen Schicht betrug 3,5 g/m².

## Patentansprüche

1. Lichthärtbares elastomeres Gemisch, das als wesentliche Bestandteile
a) ein amphiphiles elastomeres Bindemittel bzw. ein Gemisch solcher Bindemittel,
b) eine radikalisch polymerisierbare, mit dem Bindemittel verträgliche Verbindung mit mindestens einer endständigen, ethylenisch ungesättigten Gruppe und einem Siedepunkt bei Normaldruck oberhalb 100 °C und
c) eine Verbindung oder eine Verbindungskombination, die unter Einwirkung von aktinischem Licht die Polymerisation der Verbindung (b) einzuleiten vermag,
enthält, dadurch gekennzeichnet, daß das Bindemittel aus den Segmenten A, B und C aufgebaut ist, wobei
A einen hydrophoben weichen Block mit einer Glastemperatur T_{g} von unter -30 °C,
B einen hydrophoben harten Block mit einer Glastemperatur T_{g} von über +30 °C,
C einen polaren Block, der aus Vinylmonomeren und/oder durch anionische Ringöffnung polymerisierbaren heterocyclischen Verbindungen aufgebaut ist, wobei die Vinylmonomere Methacrylate, Vinylpyridine oder substituierte Vinylpyridine sind,
bedeuten.

2. Lichthärtbares elastomeres Gemisch nach Anspruch 1, dadurch gekennzeichnet, daß das als Bindemittel dienende elastomere Blockcopolymerisat zu 20 bis 99 Gew.-% aus den Polymerblöcken A, zu 1 bis 50 Gew.-% aus den Polymerblöcken B und zu 1 bis 50 Gew.-% aus den Polymerblöcken C besteht.

3. Lichthärtbares elastomeres Gemisch nach Anspruch 1, dadurch gekennzeichnet, daß in dem als Bindemittel dienenden elastomeren Blockcopolymerisat die weichen Polymerblöcke A aus konjugierten Dienen, die harten Polymerblöcke B aus Vinylaromaten und die polaren Blöcke C aus Methacrylaten, Vinylpyridinen, Oxiranen, Thietanen, Lactonen, Cyclosiloxanen oder Lactamen gebildet sind.

4. Lichthärtbares elastomeres Gemisch nach Anspruch 3, dadurch gekennzeichnet, daß das konjugierte Dien 1,3-Butadien, Isopren oder 2,3-Dimethyl-1,3-butadien ist.

5. Lichthärtbares elastomeres Gemisch nach Anspruch 3, dadurch gekennzeichnet, daß der Vinylaromat Styrol ist.

6. Lichthärtbares elastomeres Gemisch nach Anspruch 1, dadurch gekennzeichnet, daß die Polymerblöcke C aus t-Butylmethacrylat, Ethylenoxid, Ethylensulfid, 4-Vinylpyridin, ε-Caprolacton und Hexamethylcyclotrisiloxan aufgebaut sind.

7. Lichthärtbares elastomeres Gemisch nach Anspruch 1, dadurch gekennzeichnet, daß das als Bindemittel dienende Blockcopolymerisat ein Molekulargewicht zwischen 15 000 und 200 000 g/mol besitzt.

8. Lichthärtbares elastomeres Gemisch nach Anspruch 1, dadurch gekennzeichnet, daß es 20 bis 95 Gew.-% elastomeres Blockcopolymerisat, 5 bis 70 Gew.-% polymerisierbare Verbindungen und 0,01 bis 10 Gew.-% Photopolymerisationsinitiator enthält.

9. Lichthärtbares elastomeres Gemisch, das als wesentliche Bestandteile
a) ein amphiphiles elastomeres Bindemittel bzw. ein Gemisch solcher Bindemittel,
b) eine radikalisch polymerisierbare, mit dem Bindemittel verträgliche Verbindung mit mindestens einer endständigen, ethylenisch ungesättigten Gruppe und einem Siedepunkt bei Normaldruck oberhalb 100 °C und
c) eine Verbindung oder eine Verbindungskombination, die unter Einwirkung von aktinischem Licht die Polymerisation der Verbindung (b) einzuleiten vermag,
enthält, dadurch gekennzeichnet, daß das Bindemittel ein Blockcopolymer der Strucktur C-A-C enthält, wobei A und C die im Anspruch 1 angegebene Bedeutung haben.

10. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 8 oder 9 besteht.

## Claims

1. Light-curable elastomeric mixture containing as substantial constituents
a) an amphiphilic elastomer binder or a mixture of such binders,
b) a free-radically polymerisable compound compatible with the binder and having at least one terminal, ethylenically unsaturated group and a boiling point at standard pressure of above 100°C and
c) a compound or combination of compounds which is capable of initiating polymerisation of compound (b) under the action of actinic light,
characterised in that the binder is synthesised from segments A, B and C, wherein
A means a hydrophobic soft block having a glass transition temperature T_{g} of below -30°C,
B means a hydrophobic hard block having a glass transition temperature T_{g} of above +30°C,
C means a polar block which is synthesised from vinyl monomers and/or heterocyclic compounds polymerisable by anionic ring opening, wherein the vinyl monomers are methacrylates, vinylpyridines or substituted vinylpyridines.

2. Light-curable elastomeric mixture according to claim 1, characterised in that the elastomeric block copolymer acting as binder consists of 20 to 99 wt.% of polymer blocks A, of 1 to 50 wt.% of polymer blocks B and of 1 to 50 wt.% of polymer blocks C.

3. Light-curable elastomeric mixture according to claim 1, characterised in that, in the elastomeric block copolymer acting as binder, the soft polymer blocks A are formed from conjugated dienes, the hard polymer blocks B from vinyl aromatics and the polar blocks C from methacrylates, vinylpyridines, oxiranes, thietanes, lactones, cyclosiloxanes or lactams.

4. Light-curable elastomeric mixture according to claim 3, characterised in that the conjugated diene is 1,3-butadiene, isoprene or 2,3-dimethyl-1,3-butadiene.

5. Light-curable elastomeric mixture according to claim 3, characterised in that the vinyl aromatic is styrene.

6. Light-curable elastomeric mixture according to claim 1, characterised in that the polymer blocks C are synthesised from t.-butyl methacrylate, ethylene oxide, ethylene sulfide, 4-vinylpyridine, ε-caprolactone and hexamethylcyclotrisiloxane.

7. Light-curable elastomeric mixture according to claim 1, characterised in that the block copolymer acting as binder has a molecular weight of between 15000 and 200000 g/mol.

8. Light-curable elastomeric mixture according to claim 1, characterised in that it contains 20 to 95 wt.% of elastomeric block copolymer, 5 to 70 wt.% of polymerisable compounds and 0.01 to 10 wt.% of photopolymerisation initiator.

9. Light-curable elastomeric mixture containing as substantial constituents
a) an amphiphilic elastomer binder or a mixture of such binders,
b) a free-radically polymerisable compound compatible with the binder and having at least one terminal, ethylenically unsaturated group and a boiling point at standard pressure of above 100°C and
c) a compound or combination of compounds which is capable of initiating polymerisation of compound (b) under the action of actinic light,
characterised in that the binder contains a block copolymer of the structure C-A-C, wherein A and C have the meaning stated in claim 1.

10. Light-curable recording material having a layer support and a light-curable layer, characterised in that the light-curable layer consists of a mixture according to one of claims 1 to 8 or 9.

## Revendications

1. Mélange élastomère photodurcissable qui contient comme constituants essentiels
a) un liant élastomère amphiphile respectivement un mélange de tels liants,
b) un composé radicalairement polymérisable compatible avec le liant présentant au moins un groupe terminal éthyléniquement insaturé et un point d'ébullition à pression atmosphérique supérieur à 100°C et
c) un composé ou une combinaison de composés qui peut initier sous l'action de lumière actinique la polymérisation du composé (b),
caractérisé en ce que le liant est constitué des segments A, B et C,
A représentant une séquence mole hydrophobe avec une température vitreuse Tg inférieure à -30°C,
B représentant une séquence dure hydrophobe avec une température vitreuse Tg supérieure à + 30°C,
C représentant une séquence polaire qui est constituée de monomères vinyliques et/ou de composés hétérocycliques polymérisables par ouverture anionique de cycle, les monomères vinyliques étant des méthacrylates, des vinylpyridines ou des vinylpyridines substituées.

2. Mélange élastomère photodurcissable selon la revendication 1, caractérisé en ce que le copolymère séquencé élastomère servant de liant est constitué jusqu'à de 20 à 99% en poids des séquences polymères A, jusqu'à de 1 à 50% en poids des séquences polymères B et jusqu'à de 1 à 50% en poids des séquences polymères C.

3. Mélange élastomère photodurcissable selon la revendication 1, caractérisé en ce que dans le copolymère séquencé élastomère servant de liant les séquences polymères molles A sont formées à partir de diènes conjugués, les séquences polymères dures B sont formées à partir de composés aromatiques vinyliques et les séquences polaires C sont formées à partir de méthacrylates, de vinylpyridines, d'oxyranes, de thiétanes, de lactones, de cyclosiloxanes ou de lactames.

4. Mélange élastomère photodurcissable selon la revendication 3, caractériséen ce que le diène conjugué est le 1,3-butadiène, l'isoprène ou le 2,3-diméthyl-1,3-butadiène.

5. Mélange élastomère photodurcissable selon la revendication 3, caractérisé en ce que le composé aromatiquee vinylique est le styrène.

6. Mélange élastomère photodurcissable selon la revendication 1, caractérisé en ce que les séquences polymères C sont constituées de méthacrylate de t-butyle, d'oxyde d'éthylène, de sulfure d'éthylène, de 4-vinylpyridine, d'ε-caprolactone et d'hexaméthylcyclotrisiloxane.

7. Mélange élastomère photodurcissable selon la revendication 1, caractérisé en ce que le copolymère séquencé servant de liant présente un poids moléculaire compris entre 15 000 et 200 000 g/mol.

8. Mélange élastomère photodurcissable selon la revendication 1, caractérisé en ce qu'il contient de 20 à 95% en poids de copolymère séquencé élastomère, de 5 à 70% en poids de composés polymérisables et de 0,01 à 10% en poids d'initiateur de photopolymérisation.

9. Mélange élastomère photodurcissable qui contient comme constituants essentiels
a) un liant élastomère amphiphile respectivement un mélange de tels liants,
b) un composé radicalairement polymérisable compatible avec le liant présentant au moins un groupe terminal éthyléniquement insaturé et un point d'ébullition à pression atmosphérique supérieur à 100°C et
c) un composé ou une combinaison de composés qui peut initier sous l'action de lumière actinique la polymérisation du composé (b),
caractérisé en ce que le liant contient un copolymère séquencé de la structure C-A-C, A et C ayant la signification indiquée dans la revendication 1.

10. Matériau d'enregistrement photodurcissable présentant une couche de support et une couche photodurcissable, caractérisé en ce que la couche photodurcissable est constituée d'un mélange selon l'une des revendications 1 à 8 ou 9.
